# EUROPÄISCHE PATENTSCHRIFT

(11) **EP 0 298 331 B1**
(45) Veröffentlichungstag und Bekanntmachung des Hinweises auf die Patenterteilung: **26.01.1994**
(21) Anmeldenummer: 88110186.9
(22) Anmeldetag: 25.06.1988
(51) Int. Cl.: H03K 17/945

(54) **Elektronisches, berührungslos arbeitendes Schaltgerät**
Electronic switching device operating without contact
Appareil de commutation électronique fonctionnant sans contact

(30) Priorität: 07.07.1987 DE 3722334
(43) Veröffentlichungstag der Anmeldung: 11.01.1989
(73) Patentinhaber: i f m electronic gmbh, D-45127 Essen (DE)
(72) Erfinder: Lamarche, Jean-Luc, Dipl.-Ing., D-7994 Langenargen (DE)
(74) Vertreter: Gesthuysen, Hans Dieter, Dipl.-Ing.

(56) Entgegenhaltungen:
- EP-A- 0 132 552
- EP-A- 0 171 013
- EP-A- 0 200 053
- DE-B- 3 004 829

## Beschreibung

Die Erfindung betrifft ein elektronisches, berührungslos arbeitendes Schaltgerät, mit einem von außen beeinflußbaren Oszillator, mit einem dem Oszillator nachgeordneten, einen Demodulator und einen Schmitttrigger aufweisenden Schaltverstärker, mit einem von dem Oszillator über den Schaltverstärker steuerbaren elektronischen Schalter, z. B. einem Transistor, einem Thyristor oder einem Triac, und mit einer Speiseschaltung zur Darstellung der Speisespannung für den Oszillator und für den Schaltverstärker, wobei zwischen dem Demodulator und dem Schmitttrigger sowie dem Oszillator eine Steuerschaltung vorgesehen ist, die Steuerschaltung einen Analogverstärker mit einem Referenzeingang, einem Steuereingang und einem Steuerausgang sowie einen Steuertransistor aufweist, der Referenzeingang des Analogverstärkers an eine Referenzspannung, der Steuereingang des Analogverstärkers an den Ausgang des Demodulators und der Steuerausgang des Analogverstärkers an die Basis des Steuertransistors angeschlossen sind und mittels der Steuerschaltung so auf den Oszillator eingewirkt wird, daß der Oszillator auch im unbeeinflußten Zustand schwingt.

Elektronische Schaltgeräte der hier grundsätzlich in Rede stehenden Art sind kontaktlos ausgeführt und werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelkreisen. Das gilt insbesondere für sogenannte Näherungsschalter, d. h. für elektronische Schaltgeräte, die berührungslos arbeiten. Mit solchen Näherungsschaltern wird indiziert, ob sich ein Beeinflussungselement, für das der entsprechende Näherungsschalter sensitiv ist, dem Näherungsschalter hinreichend weit genähert hat. Hat sich nämlich ein Beeinflussungselement, für das der entsprechende Näherungsschalter sensitiv ist, dem Näherungsschalter hinreichend weit genähert, so wird der elektronische Schalter umgesteuert; bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der hier grundsätzlich in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil des elektronischen Schaltgerätes, von dem die Erfindung ausgeht, ist der von außen beeinflußbare Oszillator. Hinsichtlich der Beeinflussung des Oszillators wird dabei zwischen induktiver und kapazitiver Beeinflussung unterschieden. Bei elektronischen, berührungslos arbeitenden Schaltgeräten mit induktiver Beeinflussung des Oszillators gilt für den Oszillator, solange ein Metallteil einen vorgegebenen Abstand noch nicht erreicht hat, K x V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkerfaktors V, so daß K x V < 1 wird, d. h. der Oszillator hört auf zu schwingen. Bei elektronischen, berührungslos arbeitenden Schaltgeräten mit kapazitiver Beeinflussung des Oszillators gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, K x V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K x V = 1 wird, d. h. der Oszillator beginnt zu schwingen. Bei beiden Ausführungsformen - induktiver Näherungsschalter und kapazitiver Näherungsschalter - wird abhängig von den unterschiedlichen Zuständen des Oszillators der elektronische Schalter, z. B. ein Transistor, ein Thyristor oder ein Triac, gesteuert.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit dem Problem "Darstellung einer Speisespannung für den Oszillator und den Schaltverstärker", "Ausbildung des Oszillators", "Kurzschlußfestigkeit" und "Einschaltimpulsverhinderung". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 039, 22 03 040, 22 03 096, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141, 30 38 692, 31 20 884, 32 05 737, 32 09 673, 32 14 836, 32 38 396, 33 20 975, 33 26 440, 33 27 328, 33 27 329, 34 20 236, 34 27 498, 35 19 714, 35 29 827, 36 05 199, 36 05 885 und 36 38 409).

Einleitend ist gesagt, daß zu dem elektronischen Schaltgerät, von dem die Erfindung ausgeht, u. a. ein dem Oszillator nachgeordneter Schaltverstärker und ein elektronischer Schalter gehören und daß der elektronische Schalter von dem Oszillator über den Schaltverstärker steuerbar ist. Schaltverstärker ist hier ganz allgemein zu verstehen und umfaßt die gesamte Schaltung zwischen dem Signalausgang des Oszillators und dem Steuereingang des elektronischen Schalters, also den gesamten Signalübertragungsweg zwischen dem Signalausgang des Oszillators und dem Steuereingang des elektronischen Schalters.

Bei den elektronischen Schaltgeräten der in Rede stehenden Art kann, wie bereits ausgeführt, der Oszillator von außen beeinflußt, nämlich durch ein Metallteil bedämpft werden und wird abhängig davon, ob der Oszillator schwingt oder nicht schwingt, der elektronische Schalter gesteuert. Konkret erfolgt die Auswertung des Schwingungsverhaltens des Oszillators durch den Demodulator - erste Funktionseinheit des Schaltverstärkers - und durch den Schmitttrigger - zweite Funktionseinheit des Schaltverstärkers. Der Demodulator macht aus der Oszillatorspannung, also einer Signalwechselspannung, eine analoge Signalgleichspannung und der Schmitttrigger macht aus der der Oszillatorspannung analogen Signalgleichspannung an seinem Signalausgang ein digitales Ausgangssignal, mit dem dann - ggf. über eine weitere Funktionseinheit des Schaltverstärkers oder über mehrere weitere Funktionseinheiten des Schaltverstärkers - der elektronische Schalter angesteuert wird. Liegt die Signalgleichspannung am Signaleingang des Schmitttriggers oberhalb einer an seinem Vergleichseingang liegenden Vergleichsspannung, so ist das Ausgangssignal z. B. logisch 1, liegt die Signalspannung unterhalb der Vergleichsspannung, so ist dann das Ausgangssignal logisch 0.

Oszillatoren benötigen nun eine bestimmte Anschwingzeit, um vom nichtschwingenden Zustand in den schwingenden Zustand zu gelangen. Diese Anschwingzeit bestimmt unmittelbar die maximale Schaltfrequenz eines elektronischen Schaltgerätes, das einen in der beschriebenen Weise beeinflußbaren Oszillator aufweist. Der minimale zeitliche Abstand zwischen zwei Beeinflussungen des Oszillators darf nicht kleienr sein als die Anschwingzeit des Oszillators: ist der zeitliche Abstand zwischen zwei Beeinflussungen des Oszillators kleiner als die Anschwingzeit des Oszillators, so bleibt der Oszillator im nichtschwingenden Zustand.

Nun werden elektronische Schaltgeräte der Art, von der die Erfindung ausgeht, u. a. auch für Zählaufgaben eingesetzt, so daß die maximale Schaltfrequenz eines solchen elektronischen Schaltgerätes von erheblicher Bedeutung ist. Folglich ist bei dem elektronischen, berührungslos arbeitenden Schaltgerät, von dem die Erfindung ausgeht (vgl. die EP - A - 0 200 053), dafür gesorgt, daß der Oszillator auch im beeinflußten Zustand schwingt. Im einzelnen ist bei diesem bekannten Schaltgerät ein fremderregter Oszillator vorgesehen. An einem aus einer Schwingkreisspule und einem Schwingkreiskondensator bestehenden Schwingkreis ist angeschlossen ein Phasenregelkreis (PLL = Phase-locked Loop); der Phasenregelkreis besteht aus einem Phasendetektor, einem Schleifenfilter und einem spannungsgesteuerten Oszillator (VCO = voltage controlled oszillator). Die Steuerschaltung, die so auf den Oszillator einwirkt, daß der Oszillator auch im beeinflußten Zustand schwingt, regelt dann, wenn das Schaltgerät bedämpft ist, die Amplitude des spannungsgesteuerten Oszillators.

Das bekannte elektronische Schaltgerät, von dem die Erfindung ausgeht, ist - mit dem beschriebenen fremderregten Oszillator - relativ aufwendig, so daß der Erfindung die Aufgabe zugrundeliegt, mit einfacheren Mitteln dafür zu sorgen, daß der Oszillator auch im beeinflußten Zustand schwingt.

Das erfindungsgemäße elektronische, berührungslos arbeitende Schaltgerät ist dadurch gekennzeichnet, daß der Oszillator, wie an sich bekannt, einen Oszillatortransistor und einen Emitterwiderstand aufweist und mittels der Kollektor-Emitter-Strecke des Steuertransistors dem Emitterwiderstand des Oszillatortransistors ein Steuerwiderstand parallelgeschaltet ist, so daß der Verstärkungsfaktor des Oszillators abhängig ist von der Signalgleichspannung am Ausgang des Demodulators.

Grundsätzlich könnte man daran denken, bei dem erfindungsgemäßen elektronischen Schaltgerät die Oszillatorspannung zu regeln, also durch eine zu einer Regelschaltung erweiterte Steuerschaltung dafür zu sorgen, daß die Oszillatorspannung im nicht beeinflußten Zustand des Oszillators und im beeinflußten Zustand des Oszillators stets gleich groß bleibt. Man müßte dann aus der für eine solche Regelung erforderlichen Stellgröße ableiten, ob der Oszillator nicht beeinflußt oder beeinflußbar ist.

Die zuvor erläuterte Realisierungsmöglichkeit eines elektronischen Schaltgerätes hat jedoch den Nachteil, daß dem Oszillator im beeinflußten Zustand relativ viel Energie zugeführt werden muß, also eine große Speiseleistung für den Oszillator benötigt wird. Eine große Speiseleistung für den Oszillator hat aber bei einem elektronischen Schaltgerät mit nur zwei Außenleitern einen unerwünscht hohen Spannungsabfall und/oder einen unerwünscht hohen Reststrom zur Folge. Vorzugsweise ist deshalb bei dem erfindungsgemäßen elektronischen Schaltgerät die Steuerschaltung zwischen den beiden Funktionseinheiten des Schaltverstärkers und dem Oszillator so ausgebildet, daß durch ihre Einwirkung auf den Oszillator die Signalgleichspannung zwischen den beiden Funktionseinheiten des Schaltverstärkers durchaus noch unterschiedliche, auswertbare Werte annimmt.

Im einzelnen gibt es nun verschiedene Möglichkeiten, daß erfindungsgemäße elektronische, berührungslos arbeitende Schaltgerät auszugestalten und weiterzubilden. Dazu wird einerseits auf die dem Patentanspruch 1 nachgeordneten Patentansprüche, andererseits auf die ein Ausführungsbeispiel darstellende Zeichnung verwiesen.

In der ein Ausführungsbeispiel darstellenden Zeichnung zeigt
- Fig. 1: ein Blockschaltbild eines elektronischen, berührungslos arbeitenden Schaltgerätes und
- Fig. 2: ein vereinfachtes Schaltbild eines Teils des erfindungsgemäßen elektronischen Schaltgerätes, nämlich den Oszillator, die erste Funktionseinheit des Schaltverstärkers, die zweite Funktionseinheit des Schaltverstärkers und die erfindungsgemäß zwischen den beiden Funktionseinheiten des Schaltverstärkers und dem Oszillator vorgesehene Steuerschaltung.

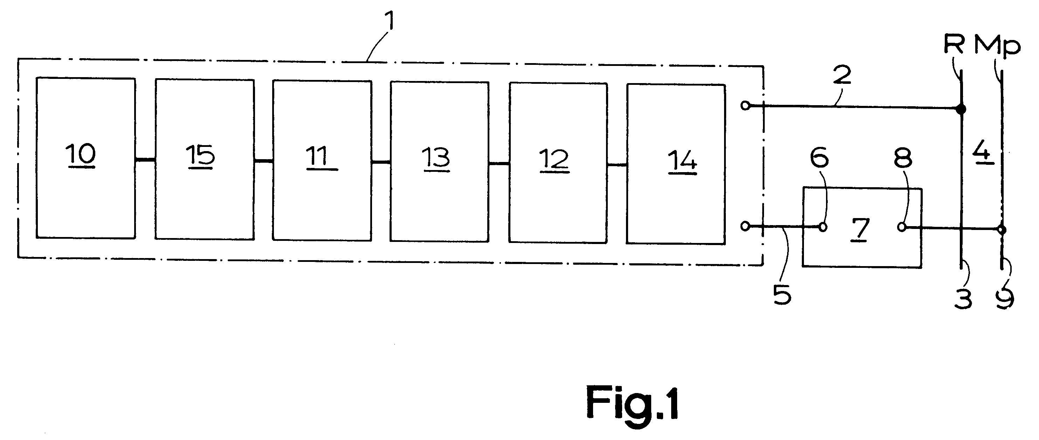

Das in Fig. 1 mit Hilfe eines Blockschaltbildes dargestellte elektronische Schaltgerät 1 arbeitet berührungslos, d. h. es spricht auf ein sich annäherndes, nicht dargestelltes Metallteil an, und ist über einen Außenleiter 2 an einen Pol 3 einer Betriebsspannungsquelle 4 und nur über einen weiteren Außenleiter 5 an einen Anschluß 6 eines Verbrauchers 7 angeschlossen, - während der andere Anschluß 8 des Verbrauchers 7 an den anderen Pol 9 der Betriebsspannungsquelle 4 angeschlossen ist. Mit anderen Worten ist das dargestellte Schaltgerät 1 in bekannter Weise über insgesamt nur zwei Außenleiter 2, 5 einerseits an die Betriebsspannungsquelle 4 und andererseits an den Verbraucher 7 angeschlossen.

Wie die Fig. 1 zeigt, besteht das dargestellte Schaltgerät 1 in seinem grundsätzlichen Aufbau aus einem von außen beeinflußbaren Oszillator 10, einem dem Oszillator 10 nachgeordneten, mindestens zwei Funktionseinheiten aufweisenden Schaltverstärker 11, einem von dem Oszillator 10 über den Schaltverstärker 11 steuerbaren elektronischen Schalter 12, z. B. einem Thyristor, und einer Speiseschaltung 13 zur Darstellung der Speisespannung für den Oszillator 10 und für den Schaltverstärker 11. Eingangsseitig ist noch eine Gleichrichterbrücke 14 vorgesehen, weil es sich bei der Betriebsspannungsquelle 4 um eine Wechselspannungsquelle handelt.

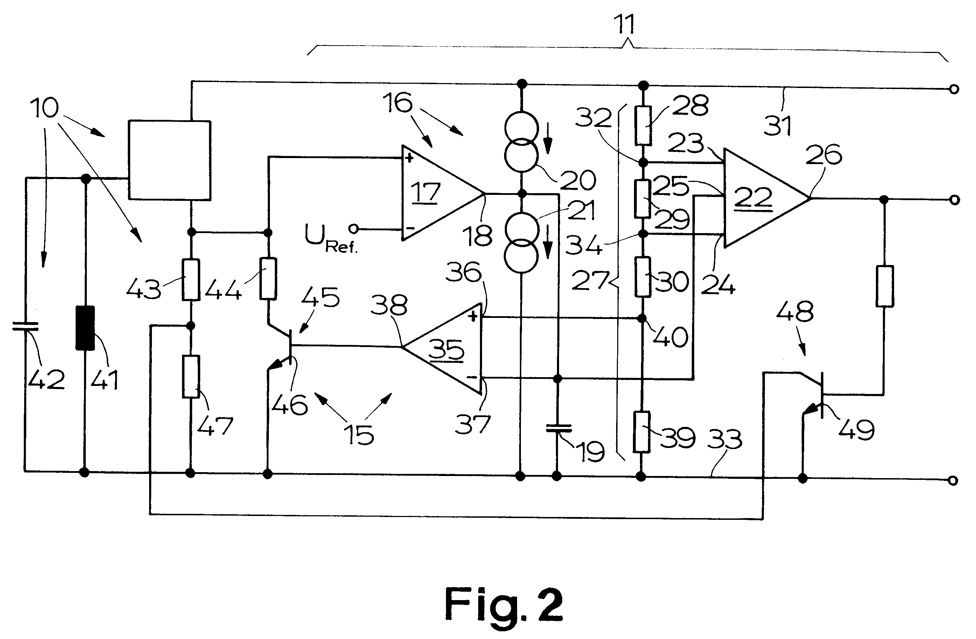

Wie nun die Fig. 2 zeigt, ist zwischen den beiden Funktionseinheiten des Schaltverstärkers 11 und dem Oszillator 10 eine Steuerschaltung 15 vorgesehen und wird mittels der Steuerschaltung 15 so auf den Oszillator 10 eingewirkt, daß der Oszillator 10 auch im beeinflußten Zustand schwingt. Bei dem dargestellten elektronischen Schaltgerät wird durch die Steuerschaltung 15 die Schwingung des Oszillators 10 im beeinflußten Zustand aufrechterhalten. Die Folge davon ist, daß der Oszillator 10 nicht mehr zwischen zwei Beeinflussungen jeweils erneut anschwingen muß, die Anschwingzeit also die maximale Schaltfrequenz des erfindungsgemäßen elektronischen Schaltgerätes 1 nicht beeinflußt.

Wie die Fig. 2 zeigt, ist die erste Funktionseinheit des Schaltverstärkers 11 als Demodulator 16 ausgeführt, wobei der Demodulator 16 eine im einzelnen nicht dargestellte Referenzspannungsquelle, einen Differenzverstärker 17, einen an den Signalausgang 18 des Differenzverstärkers 17 angeschlossenen Demodulatorkondensator 19, einen an den Signalausgang 18 des Differenzverstärkers 17 angeschlossenen Lade-Konstantstromgenerator 20 und einen an den Signalausgang 18 des Differenzverstärkers 17 angeschlossenen Entlade-Konstantstromgenerator 21 aufweist und der Demodulatorkondensator 19 über den Lade-Konstantstromgenerator 20 mit einem konstanten Ladestrom geladen und über den Entlade-Konstantstromgenerator 21 mit einem konstanten Entladestrom entladen wird. Vorzugsweise ist der konstante Ladestrom größer, insbesondere um den Faktor 2 - 3 größer als der konstante Entladestrom. Im einzelnen wird dazu auf die DE-PS 30 04 829, insbesondere auf Spalte 4, Zeile 17 ff. verwiesen.

Wie die Fig. 2 nun weiter zeigt, ist die zweite Funktionseinheit des Schaltverstärkers 11 als Schmitttrigger 22 ausgeführt, wobei der Schmitttrigger 22 zwei Vergleichseingänge 23, 24, einen Steuereingang 25 und einen Signalausgang 26 aufweist und der Steuereingang 25 des Schmitttriggers 22 mit dem Demodulatorkondensator 19 verbunden ist. Desweiteren ist ein Spannungsteiler 27 vorgesehen, der zunächst drei Spannungsverteilerwiderstände 28, 29, 30 aufweist und an die Speisespannung angeschlossen ist. Ein Vergleichseingang 23 des Schmitttriggers 22 ist an den dem Pluspol 31 der Speisespannung nahen Verbindungspunkt 32 der Spannungsteilerwiderstände 28, 29 angeschlossen, während der andere Vergleichseingang 24 des Schmitttriggers 22 an den dem Minuspol 33 der Speisespannung nahen Verbindungspunkt 34 der Spannungsteilerwiderstände 29, 30 angeschlossen ist.

Wie die Fig. 2 weiter zeigt, weist die Steuerschaltung 15 einen Analogverstärker 35 mit einem Referenzeingang 36, einem Steuereingang 37 und einem Steuerausgang 38 auf. Dabei sind der Referenzeingang 36 an eine Referenzspannung, der Steuereingang 37 an den Demodulatorkondensator 19 und der Steuerausgang 38 an den Oszillator 10 angeschlossen.

Im einzelnen gilt für das in Fig. 2 dargestellte Ausführungsbeispiel weiter, daß der Spannungsteiler 27 einen vierten Spannungsteilerwiderstand 39 aufweist und mit dem vierten Spannungsteilerwiderstand 39 an den Minuspol 33 der Speisespannung angeschlossen ist und der Referenzeingang 36 des Analogverstärkers 35 der Steuerschaltung 15 an den Verbindungspunkt 40 zwischen dem dritten Spannungsteilerwiderstand 30 und dem vierten Spannungsteilerwiderstand 39 angeschlossen ist.

Die Fig. 2 zeigt von dem in Fig. 1 dargestellten elektronischen Schaltgerät 1 nur - und nur stark vereinfacht - den Oszillator 10, den Schaltverstärker 11 mit den beiden Funktionseinheiten Demodulator 16 und Schmitttrigger 22 sowie die Steuerschaltung 15. Insbesondere in bezug auf den Oszillator 10 können der Fig. 2 Details nicht entnommen werden, insbesondere kann der Fig. 2 nicht entnommen werden, daß der Oszillator 10 einen Oszillatortransistor bzw. mehrere Oszillatortransistoren aufweist. Als zum Oszillator 10 gehörend dargestellt sind im einzelnen nur eine Schwingkreisspule 41, ein Schwingkreiskondensator 42 und ein Emitterwiderstand 43, der im Emitterkreis des im einzelnen nicht dargestellten Oszillatortransistors liegt. Mittels der Steuerschaltung 15 ist dem Emitterwiderstand 43 des Oszillatortransistors ein Steuerwiderstand 44 parallelschaltbar. Im einzelnen ist dies dadurch realisiert, daß die Steuerschaltung 15 einen Steuertransistor 45 aufweist, die Basis 46 des Steuertransistors 45 an den Steuerausgang 38 des Analogverstärkers 35 angeschlossen ist und der Steuerwiderstand 44 mittels der Kollektor-Emitter-Strecke des Steuertransistors 45 dem Emitterwiderstand 43 des Oszillatortransistors - mehr oder weniger wirksam - parallelschaltbar ist. Mit "mehr oder weniger wirksam" ist dabei gemeint, daß der über den Steuerwiderstand 44 fließende Strom und damit die Beeinflussung des Verstärkungsfaktors des Oszillators 10 abhängig ist vom Analogverstärker 35, also abhängig von der Referenzspannung am Referenzeingang 36 des Analogverstärkers 35 und von der Signalgleichspannung am Steuereingang 37 des Analogverstärkers 35, also von der Signalgleichspannung am Demodulatorkondensator 19.

Im übrigen zeigt Fig. 2 noch insoweit ein bevorzugtes Ausführungsbeispiel des in Fig. 1 dargestellten elektronischen Schaltgerätes, als ein Hysteresewiderstand 47 und ein Hysteresetransistor 48 vorgesehen sind, der Hysteresewiderstand 47 in Reihe zum Emitterwiderstand 43 des Oszillatortransistors liegt, die Basis 49 des Hysteresetransistors 48 an den Signalausgang 26 des Schmitttriggers 22 angeschlossen ist und die Kollektor-Emitter-Strecke des Hysteresetransistors 48 dem Hysteresewiderstand 47 parallelgeschaltet ist. Dazu wird im einzelnen auf die DE-PS 19 66 178 verwiesen.

## Patentansprüche

1. Elektronisches, berührungslos arbeitendes Schaltgerät, mit einem von außen beeinflußbaren Oszillator (10), mit einem dem Oszillator (10) nachgeordneten, einen Demodulator (16) und einen Schmitttrigger (22) aufweisenden Schaltverstärker (11), mit einem von dem Oszillator (10) über den Schaltverstärker (11) steuerbaren elektronischen Schalter (12), z. B. einem Transistor, einem Thyristor oder einem Triac, und mit einer Speiseschaltung (13) zur Darstellung der Speisespannung für den Oszillator (10) und für den Schaltverstärker (11), wobei zwischen dem Demodulator (16) und dem Schmitttrigger (22) sowie dem Oszillator (10) eine Steuerschaltung (15) vorgesehen ist, die Steuerschaltung (15) einen Analogverstärker (35) mit einem Referenzeingang (36), einem Steuereingang (37) und einem Steuerausgang (38) sowie einen Steuertransistor (45) aufweist, der Referenzeingang (36) des Analogverstärkers (35) an eine Referenzspannung, der Steuereingang (37) des Analogverstärkers (35) an den Ausgang des Demodulators (16) und der Steuerausgang (38) des Analogverstärkers (35) an die Basis (46) des Steuertransistors (45) angeschlossen sind und mittels der Steuerschaltung (15) so auf den Oszillator (10) eingewirkt wird, daß der Oszillator (10) auch im beeinflußten Zustand schwingt, **dadurch gekennzeichnet**, daß der Oszillator (10) einen Oszillatortransistor mit einem Emitterwiderstand (43) aufweist und mittels der Kollektor-Emitter-Strecke des Steuertransistors (45) dem Emitterwiderstand (43) des Oszillatortransistors ein Steuerwiderstand (44) parallelschaltbar ist, so daß der Verstärkungsfaktor des Oszillators (10) Kontinuierlich abhängig ist von der Signalgleichspannung am Ausgang des Demodulators (16).

2. Elektronisches Schaltgerät nach Anspruch 1, dadurch gekennzeichnet, daß der Demodulator (16), wie an sich bekannt, eine Referenzspannungsquelle, einen Differenzverstärker (17) und einen - direkt oder indirekt - an den Signalausgang (18) des Differenzverstärkers (17) angeschlossenen Demodulatorkondensator (19) aufweist.

3. Elektronisches Schaltgerät nach Anspruch 2, dadurch gekennzeichnet, daß der Steuereingang (37) des Analogverstärkers (35) an den Demodulatorkondensator (19) angeschlossen ist.

4. Elektronisches Schaltgerät nach Anspruch 2 oder 3, dadurch gekennzeichnet, daß der Demodulator, wie an sich bekannt, einen Schalttransistor, einen Ladewiderstand und ein Konstantstromnetzwerk aufweist und der Demodulatorkondensator über das Konstantstromnetzwerk mit einem konstanten Ladestrom geladen und mit einem konstanten Entladestrom entladen wird.

5. Elektronisches Schaltgerät nach Anspruch 3, dadurch gekennzeichnet, daß an den Signalausgang (18) des Differenzverstärkers (17) ein Lade-Konstantstromgenerator (20) und ein Entlade-Konstantstromgenerator (21) angeschlossen sind und der Demodulatorkondensator (19) über den Lade-Konstantstromgenerator (2) mit einem konstanten Ladestrom geladen und über den Entlade-Konstantstromgenerator (21) mit einem konstanten Entladestrom entladen wird.

6. Elektronisches Schaltgerät nach Anspruch 4, oder 5, dadurch gekennzeichnet, daß der konstante Ladestrom größer, vorzugsweise um den Faktor 2 - 3 größer ist als der konstante Entladestrom.

7. Elektronisches Schaltgerät nach einem der Ansprüche 1 bis 6, dadurch gekennzeichnet, daß der Schmitttrigger (22) zwei Vergleichseingänge (23, 24), einen Steuereingang (25) und einen Signalausgang (26) aufweist und der Steuereingang (25) des Schmitttriggers (22) mit dem Demodulatorkondensator (19) verbunden ist.

8. Elektronisches Schaltgerät nach Anspruch 7, dadurch gekennzeichnet, daß ein Spannungsteiler (27) vorgesehen ist, der Spannungsteiler (27) drei Spannungsteilerwiderstände (28, 29, 30) aufweist und an die Speisespannung angeschlossen ist und ein Vergleichseingang (23) des Schmitttriggers (22) an den dem Pluspol (31) der Speisespannung nahen Verbindungspunkt (32) der Spannungsteilerwiderstände (28, 29), der andere Vergleichseingang (24) des Schmitttriggers (22) an den dem Minuspol (33) der Speisespannung nahen Verbindungspunkt (34) der Spannungsteilerwiderstände (29, 30) angeschlossen ist.

9. Elektronisches Schaltgerät nach Anspruch 8, dadurch gekennzeichnet, daß der Spannungsteiler (27) einen vierten Spannungsteilerwiderstand (39) aufweist und mit dem vierten Spannungsteilerwiderstand (39) an den Minuspol (33) der Speisespannung angeschlossen ist und der Referenzeingang (36) des Analogverstärkers (35) der Steuerschaltung (15) an den Verbindungspunkt (40) zwischen dem dritten Spannungsteilerwiderstand (30) und dem vierten Spannungsteilerwiderstand (39) angeschlossen ist.

10. Elektronisches Schaltgerät nach einem der Ansprüche 1 bis 9, dadurch gekennzeichnet, daß ein Hysteresewiderstand (47) und ein Hysteresetransistor (48) vorgesehen sind, der Hysteresewiderstand (47) in Reihe zum Emitterwiderstand (43) des Oszillatortransistors liegt, die Basis (49) des Hysteresetransistors (48) an den Signalausgang (26) des Schmitttriggers (22) angeschlossen ist und die Kollektor-Emitter-Strecke des Hysteresetransistors (48) dem Hysteresewiderstand (47) parallelgeschaltet ist.

## Claims

1. An electronic switching device operating without contact, with an externally influenceable oscillator (10), with a switching amplifier (11) having a demodulator (16) and a Schmitt trigger (22) connected downstream of the oscillator (10), with an electronic switch (12), e.g. a transistor, a thyristor or a triac which can be controlled by the oscillator (10) via the switching amplifier (11), and with a supply circuit (13) for the production of the supply voltage for the oscillator (10) and for the switching amplifier (11), wherein a control circuit (15) is provided between the demodulator (16) and Schmitt trigger (22) and the oscillator (10), the control circuit (15) comprises an analogue amplifier (35) with a reference input (36), a control input (37) and a control output (38), and a control transistor (45), the reference input (36) of the analogue amplifier (35) is connected to a reference voltage, the control input (37) of the analogue amplifier (35) is connected to the output of the demodulator (16) and the control output (38) of the analogue amplifier (35) is connected to the base (46) of the control transistor (45), and the oscillator (10) is acted upon by means of the control circuit (15) so that the oscillator (10) also vibrates in its influenced state, characterised in that the oscillator (10) comprises an oscillator transistor with an emitter resistor (43), and a control resistor (44) can be connected in parallel with the emitter resistor (43) of the oscillator transistor by means of the collector-emitter segment of the control transistor (45) so that the amplification factor of the oscillator (10) is continuously dependent on the DC signal voltage at the output of the demodulator (16).

2. An electronic switching device according to claim 1, characterised in that the demodulator (16) comprises, as is known in the art, a reference voltage source, a differential amplifier (17) and a demodulator capacitor (19) connected - directly or indirectly - to the signal output (18) of the differential amplifier (17).

3. An electronic switching device according to claim 2, characterized in that the control input (37) of the analogue amplifier (35) is connected to the demodulator capacitor (19).

4. An electronic switching device according to claim 2 or 3, characterized in that the demodulator comprises, as is known in the art, a switching transistor, a charging resistance and a constant current network, and the demodulator capacitor is charged at a constant charging current and discharged at a constant discharge current via the constant current network.

5. An electronic switching device according to claim 3, characterized in that a charging constant current generator (20) and a discharge constant current generator (21) are connected to the signal output (18) of the differential amplifier (17), and the demodulator capacitor (19) is charged at a constant charging current via the charging constant current generator (21) and is discharged at a constant discharge current via the discharge constant current generator (21).

6. An electronic switching device according to claim 4 or 5, characterized in that the constant charging current is greater, preferably by a factor of 2 - 3, than the constant discharge current.

7. An electronic switching device according to any one of claims 1 to 6, characterized in that the Schmitt trigger (22) comprises two comparison inputs (23, 24), one control input (25) and one signal output (26), and the control input (25) of the Schmitt trigger (22) is connected to the demodulator capacitor (19).

8. An electronic switching device according to claim 7, characterized in that a voltage divider (27) is provided, the voltage divider (27) has three voltage divider resistors (28, 29, 30) and is connected to the supply voltage, and one comparison input (23) of the Schmitt trigger (22) is connected to the connection point (32) of the voltage divider resistors (28, 29) near the positive pole (31) of the supply voltage and the other comparison input (24) of the Schmitt trigger (22) is connected to the connection point (34) of the voltage divider resistors (29, 30) near the negative pole (33) of the supply voltage.

9. An electronic switching device according to claim 8, characterised in that the voltage divider (27) comprises a fourth voltage divider resistor (39) and is connected by means of the fourth voltage divider resistor (39) to the negative pole (33) of the supply voltage, and the reference input (36) of the analogue amplifier (35) of the control circuit (15) is connected to the connection point (40) between the third voltage divider resistor (30) and the fourth voltage divider resistor (39).

10. An electronic switching device according to any one of claims 1 to 9, characterized in that a hysteresis resistor (47) and a hysteresis transistor (48) are provided, the hysteresis resistor (47) is connected in series with the emitter resistor (43) of the oscillator transistor, the base (49) of the hysteresis transistor (48) is connected to the signal output (26) of the Schmitt trigger (22) and the collector-emitter segment of the hysteresis transistor (48) is connected in parallel with the hysteresis resistor (47).

## Revendications

1. Appareil de commutation électronique fonctionnant sans contact, comprenant un oscillateur (10) qui peut être influencé par l'extérieur, un amplificateur de commande (11) monté en aval de l'oscillateur (10) et muni d'un démodulateur (16) et d'une bascule de Schmitt (22), un commutateur électronique (12), par exemple un transistor, un thyristor ou un triac, pouvant être commandé par l'oscillateur (10) par l'intermédiaire de l'amplificateur de commande (11), et un circuit d'alimentation (13) pour la fourniture de la tension d'alimentation pour l'oscillateur (10) et pour l'amplificateur de commande (11), entre le démodulateur (16) et la bascule de Schmitt (22) ainsi que l'oscillateur (10) étant prévu un circuit de commande (15), ledit circuit de commande (15) comprenant un amplificateur analogique (35) avec une entrée de référence (36), une entrée de commande (37) et une sortie de commande (38) ainsi qu'un transistor de commande (45), l'entrée de référence (36) de l'amplificateur analogique (35) étant reliée à une tension de référence, l'entrée de commande (37) de l'amplificateur analogique (35) étant reliée à la sortie du démodulateur (16), et la sortie de commande (38) de l'amplificateur analogique (35) étant reliée à la base (46) du transistor de commande (45), et le circuit de commande (15) agissant sur l'oscillateur (10) de telle façon que ledit oscillateur (10) oscille également à l'état influencé, **caractérisé par le fait** que l'oscillateur (10) comprend un transistor d'oscillateur avec une résistance d'émetteur (43) et que, au moyen du trajet collecteur-émetteur du transistor de commande (45), une résistance de commande (44) peut être montée en parallèle avec la résistance d'émetteur (43) du transistor d'oscillateur, de telle façon que le facteur d'amplification de l'oscillateur (10) dépend en continu de la tension continue de signal à la sortie du démodulateur (16).

2. Appareil de commutation électronique selon la revendication 1, caractérisé par le fait que le démodulateur (16) comprend, de la manière bien connue en soi, une source de tension de référence, un amplificateur différenciateur (17) et un condensateur de démodulateur (19) relié - directement ou indirectement - à la sortie de signal (18) de l'amplificateur différenciateur (17).

3. Appareil de commutation électronique selon la revendication 2, caractérisé par le fait que l'entrée de commande (37) de l'amplificateur analogique (35) est reliée au condensateur de démodulateur (19).

4. Appareil de commutation électronique selon l'une des revendications 2 ou 3, caractérisé par le fait que le démodulateur comprend, de la manière bien connue en soi, un transistor de commande, une résistance de charge et un réseau de courant constant, et que, par l'intermédiaire du réseau de courant constant, le condensateur de démodulateur est chargé avec un courant de charge constant et déchargé avec une courant de décharge constant.

5. Appareil de commutation électronique selon la revendication 3, caractérisé par le fait qu'à la sortie de signal (18) de l'amplificateur différenciateur (17) sont reliés un générateur de courant de charge constant (20) et un générateur de courant de décharge constant (21) et que le condensateur de démodulateur (19) est chargé avec un courant de charge constant par l'intermédiaire du générateur de courant de charge constant (20) et déchargé avec un courant de décharge constant par l'intermédiaire du générateur de courant de décharge constant (21).

6. Appareil de commutation électronique selon l'une des revendications 4 ou 5, caractérisé par le fait que le courant de charge constant est supérieur, de préférence supérieur du facteur 2 à 3, au courant de décharge constant.

7. Appareil de commutation électronique selon l'une des revendications 1 à 6, caractérisé par le fait que la bascule de Schmitt (22) comporte deux entrées de comparaison (23, 24), une entrée de commande (25) et une sortie de signal (26), et que l'entrée de commande (25) de la bascule de Schmitt (22) est reliée au condensateur de démodulateur (19).

8. Appareil de commutation électronique selon la revendication 7, caractérisé par le fait qu'il est prévu un diviseur de tension (27), que le diviseur de tension (27) comporte trois résistances de diviseur de tension (28, 29, 30) et est relié à la tension d'alimentation, que l'une des entrées de comparaison (23) de la bascule de Schmitt (22) est reliée au point de jonction (32) des résistances de diviseur de tension (28, 29) proche du pôle positif (31) de la tension d'alimentation, et que l'autre entrée de comparaison (24) de la bascule de Schmitt (22) est reliée au point de jonction (34) des résistances de diviseur de tension (29, 30) proche du pôle négatif (33) de la tension d'alimentation.

9. Appareil de commutation électronique selon la revendication 8, caractérisé par le fait que le diviseur de tension (27) comprend une quatrième résistance de diviseur de tension (39), que la quatrième résistance de diviseur de tension (39) est reliée au pôle négatif (33) de la tension d'alimentation, et que l'entrée de référence (36) de l'amplificateur analogique (35) du circuit de commande (15) est reliée au point de jonction (40) entre la troisième résistance de diviseur de tension (30) et la quatrième résistance de diviseur de tension (39).

10. Appareil de commutation électronique selon l'une des revendications 1 à 9, caractérisé par le fait qu'il comprend une résistance d'hystérésis (47) et un transistor d'hystérésis (48), que la résistance d'hystérésis (47) est montée en série avec la résistance d'émetteur (43) du transistor d'oscillateur, que la base (49) du transistor d'hystérésis (48) est reliée à la sortie de signal (26) de la bascule de Schmitt (22), et que le trajet collecteur-émetteur du transistor d'hystérésis (48) est monté en parallèle avec la résistance d'hystérésis (47).
